(19) Europäisches Patentamt
European Patent Office
Office européen des brevets

(11) **EP 1 249 074 B1**

(12) **EUROPÄISCHE PATENTSCHRIFT**

(45) Veröffentlichungstag und Bekanntmachung des Hinweises auf die Patenterteilung:
**31.03.2004 Patentblatt 2004/14**

(21) Anmeldenummer: 01907363.4

(22) Anmeldetag: **15.01.2001**

(51) Int Cl.⁷: $H03M\ 13/29$

(86) Internationale Anmeldenummer:
**PCT/DE2001/000154**

(87) Internationale Veröffentlichungsnummer:
**WO 2001/054286 (26.07.2001 Gazette 2001/30)**

(54) **VERFAHREN ZUR DECODIERUNG EINES DATENSIGNALS**

METHOD FOR DECODING A DATA SIGNAL

PROCEDE DE DECODAGE D'UN SIGNAL DE DONNEES

(84) Benannte Vertragsstaaten:
**AT BE CH CY DE DK ES FI FR GB GR IE IT LI LU MC NL PT SE TR**

(30) Priorität: **18.01.2000 DE 10001856**

(43) Veröffentlichungstag der Anmeldung:
**16.10.2002 Patentblatt 2002/42**

(73) Patentinhaber: **Infineon Technologies AG**
**81669 München (DE)**

(72) Erfinder:
• **BECKER, Burkhard**
**85737 Ismaning (DE)**
• **DOETSCH, Markus**
**CH-3098 Schliern (CH)**
• **JUNG, Peter**
**67697 Otterberg (DE)**
• **KELLA, Tideya**
**80337 München (DE)**
• **PLECHINGER, Jörg**
**80469 München (DE)**
• **SCHMIDT, Peter**
**67167 Erpolzheim (DE)**
• **SCHNEIDER, Michael**
**81541 München (DE)**

(74) Vertreter: **Lange, Thomas, Dr.**
**Patentanwälte**
**Lambsdorff & Lange**
**Dingolfinger Strasse 6**
**81673 München (DE)**

(56) Entgegenhaltungen:
EP-A- 0 963 048    US-A- 5 933 462
US-A- 6 014 411    US-A- 6 128 765

• BAI B ET AL: "Novel algorithm for continuous decoding of turbo codes" IEE PROCEEDINGS: COMMUNICATIONS,INSTITUTION OF ELECTRICAL ENGINEERS,GB, Bd. 146, Nr. 5, 14. Oktober 1999 (1999-10-14), Seiten 271-274, XP002168041 ISSN: 1350-2425

**Beschreibung**

Die Erfindung betrifft ein Verfahren zur Decodierung eines über einen Funkkanal übertragenen, mit einem Turbo-Code fehlerschutzcodierten Datensignals.

In Kommunikationssystemen, beispielsweise Mobilfunksystemen, wird das zu übertragende Signal (beispielsweise Sprachsignal) nach Aufbereitung in einem Quellencodierer einer Kanalcodierung unterzogen. Die Kanalcodierung dient dazu, das zu übertragende Signal an die Eigenschaften des Übertragungskanals anzupassen. Dabei wird durch gezieltes Einbringen von Redundanz in das zu übertragende Signal ein effektiver Fehlerschutz erreicht.

Binäre, parallel verkettete rekursive Faltungscodes werden als sog. "Turbo-Codes" bezeichnet. Turbo-Codes stellen insbesondere bei der Übertragung großer Datenblöcke eine leistungsfähige Form der Fehlerschutzcodierung dar.

Zum Decodieren von Turbo-Codes wird im Empfänger ein Turbo-Decodierer eingesetzt. Ein Turbo-Decodierer enthält zwei einzelne Faltungsdecodierer, die rückkopplungsartig miteinander verschaltet sind.

Bei Faltungsdecodierern wird zwischen Symbolschätzern - die nach einem symbolweisen Algorithmus arbeiten - und Folgenschätzern unterschieden. Eine spezielle Form eines Symbolschätzers ist ein MAP-Symbolschätzer. Ein solcher arbeitet nach dem sogenannten MAP- (Maximum a-Posteriori) Algorithmus. MAP-Symbolschätzer weisen den Vorteil auf, daß mit Ihnen ein geringstmögliches Bitfehlerverhältnis erreichbar ist.

Aus dem den nächstliegenden Stand der Technik repräsentierenden Buch "Analyse und Entwurf digitaler Mobilfunksysteme", von P. Jung, Stuttgart, B.G. Teubner, 1997 auf den Seiten 343 - 368, insbesondere Bild E.2, ist ein Turbo-Decodierer mit zwei rekursiv verschalteten MAP-Symbolschätzern bekannt. Zwischen den beiden MAP-Symbolschätzern ist ein Turbo-Code Verschachteler angeordnet.

Bei einer blockweisen Turbo-Code Decodierung wird ein decodiertes Datensymbol auf der Basis von Eingangsfolgen einer endlichen Anzahl N von Bits geschätzt. N wird als Blockgröße bezeichnet.

Zur Berechnung der decodierten Datenwerte wird in jedem MAP-Symbolschätzer ein Rekursionsverfahren angewendet. Das Rekursionsverfahren umfaßt eine Vorwärtsrekursion und eine Rückwärtsrekursion. Beide Rekursionen werden über die gesamte Blocklänge (d.h. vom ersten Bit des Blocks bis zum letzten Bit des Blocks bzw. vom letzten Bit des Blocks bis zum ersten Bit des Blocks) durchgeführt.

Dabei ergibt sich das Erfordernis, die bei den Rekursionen erhaltenen Ergebnisdaten in dem MAP-Symbolschätzer zwischenzuspeichern. Der MAP-Symbolschätzer benötigt daher einen Speicher, dessen Größe ausreichend für die Abspeicherung von Ergebnisdaten der Vorwärts- und der Rückwärtsrekursion bezüglich mindestens eines Datenblocks ist.

Folglich wird (insbesondere bei der Decodierung von großen Datenblöcken, bei denen die besonderen Vorteile der Turbo-Decodierung zum Tragen kommen) ein großer Speicherbedarf im MAP-Symbolschätzer benötigt.

Dies ist nachteilig, da in Mobilstationen die erforderliche Speichergröße einen wesentlichen Kostenfaktor darstellt.

In der Schrift US 5,933,462 ist ein Symbolschätzer beschrieben, der nach dem MAP-Algorithmus arbeitet und in einem Turbo-Decodierer eingesetzt werden kann. In Bezug auf einen Viterbi-Decodierer wird eine abschnittsweise Durchführung von Vorwärts- und Rückwärts-Rekursionsläufen vorgeschlagen.

In dem Artikel "Novel Algorithm for Continuous Decoding of Turbo Codes", B. Bai et al., IEE Proceedings Communications, Vol. 146, No. 5, Seiten 271 - 274, ist ein Turbo-Decodierer beschrieben. Der Schrift ist zu entnehmen, dass eine Gleitfenstertechnik für die Turbo-Decodierung zur Anwendung kommen kann.

Der Erfindung liegt die Aufgabe zugrunde, ein Verfahren zur Decodierung eines mit einem Turbo-Code fehlerschutzcodierten Datensignals anzugeben, welches einen möglichst geringen Speicherplatzbedarf hat, d.h. die Realisierung kostengünstiger Turbo-Decodierer gestattet.

Zur Lösung der Aufgabe sind die Merkmale des Anspruchs 1 vorgesehen.

Demnach werden bei dem erfindungsgemäßen Verfahren der bislang blockweise durchgeführte Vorwärtsrekursionslauf und/oder der bislang blockweise durchgeführte Rückwärtsrekursionslauf durch mehrere segmentweise (bezüglich eines betrachteten Datenblocks) erfolgende Vorwärts- bzw. Rückwärtsrekursionsläufe ersetzt. Für die Berechnung eines bestimmten decodierten Ausgabewertes des betrachteten MAP-Symbolschätzers bedeutet dies, daß anstelle der starren, blockweisen Rekursionen lediglich eine Vorwärts- und/oder Rückwärtsrekursion über ein geeignet wählbares Teilintervall des Datenblocks erforderlich ist. Dadurch wird die Anzahl der in dem betrachteten MAP-Symbolschätzer zwischenzuspeichernden Ergebnisdaten deutlich verkleinert, d.h. eine kostengünstigere Hardwarestruktur ermöglicht. Erfindungsgemäß ist dabei ein Teilintervall für eine vorwärtsrekursion D(VR) Datenwerte lang, ein Teilintervall für die Rückwärtsrekursion D(RR) Datenwerte lang, und es gilt D(RR) = D(VR) x L, wobei L die Rückgriffstiefe eines bei der Codierung eingesetzten rekursiven Faltungscodierers ist.

Eine besonders bevorzugte Vorgabe der Rekursionsintervallgrenzen kennzeichnet sich dadurch, daß jedem Teilintervall für eine Vorwärtsrekursion ein Teilintervall für eine Rückwärtsrekursion zugeordnet ist, welches das Teilintervall für die Vorwärtsrekursion enthält, und daß der Berechnung des n-ten Ausgabewertes des Datenblocks lediglich eine Vorwärtsrekursion über das den n-ten Datenwert enthaltende Teilintervall und eine Rückwärtsrekursion über das zugeordnete Teilintervall zugrunde liegen.

Vorzugsweise liegt die Länge eines Teilintervalls für die Vorwärtsrekursion zwischen 10 und 30 Datenwerten, insbesondere bei 20 Datenwerten.

Zur Verringerung des Signalverarbeitungsaufwands kann das erfindungsgemäße Verfahren in vorteilhafter Weise mit einem Berechnungsverfahren zur Ermittlung der Ausgangswerte der Symbolschätzer kombiniert werden, welches auf einem suboptimalen MAP-Algorithmus basiert. Ein suboptimaler MAP-Algorithmus ist eine aufwandsreduzierte Version des MAP-Algorithmus, der (im Gegensatz zu dem MAP-Algorithmus) zwar kein maximales Bitfehlerverhälnis der Ausgabewerte ermöglicht, jedoch weniger Rechenschritte umfaßt. Durch die genannte Kombination (segmentweise Rekursion, suboptimaler MAP-Algorithmus) wird ein Turbo-Decodierverfahren geschaffen, das einen für praktische Anwendungen ausgesprochen günstigen Kompromiß zwischen Speicherbedarf und Rechenaufwand bildet.

Weitere vorteilhafte Ausgestaltungen der Erfindung sind in den Unteransprüchen angegeben.

Die Erfindung wird nachfolgend anhand eines Ausführungsbeispiels unter Bezugnahme auf die Zeichnung erläutert; in dieser zeigt:

Fig. 1     eine schematische Darstellung der Luftschnittstelle eines Mobilfunksystems mit Sender und Empfänger;

Fig. 2     ein Blockschaltbild eines Turbo-Codierers zur Erzeugung eines Turbo-Codes;

Fig. 3     ein Blockschaltbild eines in Fig. 2 dargestellten RSC-Faltungscodierers;

Fig. 4     ein Blockschaltbild des in Fig. 1 dargestellten Turbo-Decodierers;

Fig. 5     eine schematische Darstellung zur Erläuterung der erfindungsgemäßen segmentweisen Vorwärts- und Rückwärtsrekursionen bei der Berechnung von Zuverlässigkeitsinformation in einem Symbolschätzer des Turbo-Decodierers; und

Fig. 6     eine schematische Darstellung zur Erläuterung von Rechenschritten, die zur Berechnung eines logarithmischen a-Posteriori Wahrscheinlichkeitsverhältnisses durchzuführen sind.

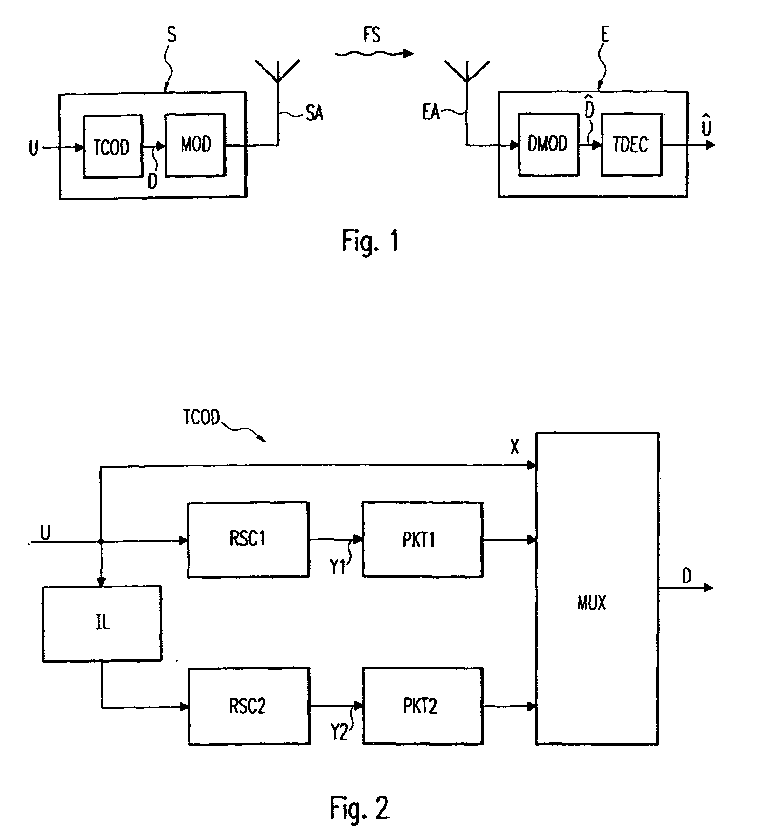

Fig. 1 zeigt einen Sender S und einen Empfänger E eines Mobilfunksystems. Der Sender S ist beispielsweise in einer Basisstation und der Empfänger E in einer Mobilstation des Mobilfunksystems enthalten.

Der Sender S weist einen Turbo-Codierer TCOD, einen Modulator MOD sowie eine Sendeantenne SA auf.

Der Turbo-Codierer TCOD nimmt ein digitales Eingabesignal in Form von Datensymbolen (beispielsweise Bits) $u_1$, $u_2$, .. entgegen. Aufgrund der blockweisen Codierung wird im folgenden eine endliche Folge U = ($u_1$, $u_2$, .., $u_N$) bestehend aus N Eingabesignal-Datensymbolen (Bits) $u_n$ , n = 1, 2, .., N betrachtet. Die Anzahl N wird wie bereits erwähnt als Blockgröße bezeichnet.

Das Eingabesignal trägt eine zu übertragende Nutzinformation, beispielsweise eine Sprachnachricht. Es kann z.B. über eine Mikrophon-Verstärker-Analog/Digital-Umsetzer Schaltungskette (nicht dargestellt) erzeugt werden.

Der Turbo-Codierer TCOD fügt dem digitalen Eingabesignal zur Fehlerschutzcodierung Redundanz hinzu. Am Ausgang des Turbo-Codierers TCOD liegt ein fehlerschutzcodiertes Datensignal in Form einer Folge D bestehend aus K Datensymbolen (Bits), D = ($d_1$, $d_2$, .., $d_K$) vor.

Das Verhältnis N/K (Anzahl von Eingabebits/Anzahl von Ausgangsbits) wird als Coderate $R_C$ eines Codierers bezeichnet.

Ein Modulator MOD moduliert das fehlerschutzcodierte Datensignal auf ein Trägersignal auf. Das mit dem fehlerschutzcodierten Datensignal modulierte Trägersignal wird in nicht dargestellter Weise von einem Sendefilter spektral geformt und von einem Sendeverstärker verstärkt, bevor es als Funksignal FS über die Sendeantenne SA abgestrahlt wird.

Der Empfänger E weist eine Empfangsantenne EA, einen Demodulator DMOD und einen Turbo-Decodierer TDEC auf.

Die Empfangsantenne EA empfängt das durch Umgebungseinflüsse und Interferenz mit Funksignalen anderer Teilnehmer gestörte Funksignal FS und führt es dem Demodulator DMOD zu.

Der Demodulator DMOD entzerrt das empfangene Funksignal FS unter Berücksichtigung der im Funkkanal erlittenen Signalstörungen. Ein am Ausgang des Demodulators DMOD bereitgestelltes entzerrtes Datensignal liegt in Form einer Symbolfolge D̃ = ($\tilde{d}_1$, $\tilde{d}_2$, .., $\tilde{d}_K$) vor, deren Elemente $\tilde{d}_1$, $\tilde{d}_2$, .., $\tilde{d}_K$ wertekontinuierliche Schätzwerte der Datensymbole $d_1$, $d_2$, .., $d_K$ der fehlerschutzcodierten Datensignalfolge D sind.

Das entzerrte Datensignal wird dem Turbo-Decodierer TDEC zugeführt, an dessen Ausgang eine decodierte Ausgabesignalfolge Û = ($\hat{u}_1$, $\hat{u}_2$, .., $\hat{u}_N$) bereitgestellt wird. Die Elemente $\hat{u}_1$, $\hat{u}_2$, .., $\hat{u}_N$ der decodierten Ausgabesignal-

folge Û sind Hypothesen der Datensymbole $u_1, u_2, .., u_N$ des sendeseitigen Eingabesignals in Form von diskreten Werten aus dem Symbolvorrat (beispielsweise 0,1) des Eingabesignals.

Die Bit-Fehlerrate wird durch die relative Häufigkeit von Fehlschätzungen $u_n \neq \hat{u}_n$, n = 1, 2, .. definiert. Sie darf bei Mobilfunkanwendungen einen bestimmten maximal zulässigen Wert nicht überschreiten.

Vor der Beschreibung eines Ausführungsbeispiels des erfindungsgemäßen Decodierverfahrens wird zum besseren Verständnis der Erfindung anhand Fig. 2 zunächst die Erzeugung eines Turbo-Codes erläutert.

Ein Turbo-Codierer TCOD weist zwei identische binäre rekursive systematische Faltungscodierer RSC1 und RSC2 auf, die in der Codiertechnik als RSC-(Recursive Systematic Convolutional-) Codierer bekannt sind. Dem zweiten RSC-Faltungscodierer RSC2 ist eingangsseitig ein Turbo-Code-Verschachteler IL vorgeschaltet, der bewirkt, daß die Codierung blockweise erfolgt. Die Ausgänge der beiden Faltungscodierer RSC1 und RSC2 sind jeweils über Punktierer PKT1 bzw. PKT2 mit einer Multiplexereinrichtung MUX verbunden. Der Multiplexereinrichtung MUX wird ferner eine Signalfolge X zugeführt, die identisch mit der digitalen Eingabesignalfolge U ist.

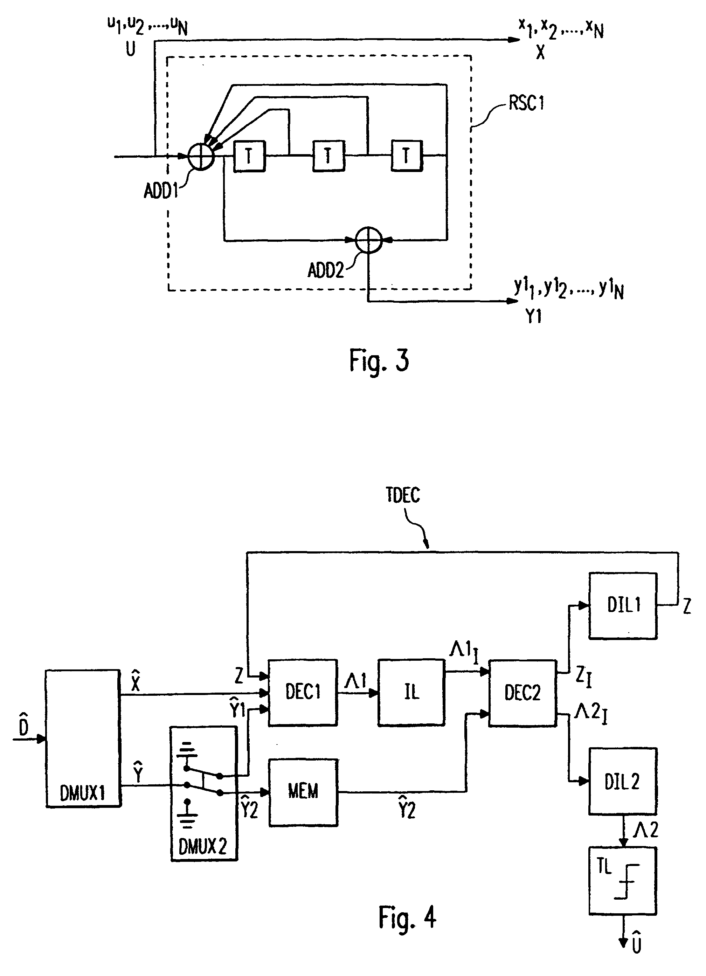

Fig. 3 zeigt am Beispiel von RSC1 den Aufbau eines rekursiven Faltungscodierers. Der Faltungscodierer RSC1 weist eingangsseitig einen ersten Addierer ADD1 und ein dem ersten Addierer ADD1 nachgeschaltetes Schieberegister mit z.B. drei Speicherzellen T auf. An seinem Ausgang stellt der Faltungscodierer RSC1 eine Redundanz-Datenfolge $Y1 = (y1_1, y1_2, .., y1_N)$ bereit, die von einem zweiten Addierer ADD2 gebildet wird.

Es wird deutlich, daß ein zu einem bestimmten Zeitpunkt am Ausgang vorliegendes Redundanz-Datensymbol $y1_n$ (n = 1, 2, .., N) von dem aktuellen Eingabe-Datensymbol $u_n$ der Eingabesignalfolge U sowie von dem Zustand des Schieberegisters abhängt. Der Zustand des Schieberegisters hängt wiederum von den letzten 3 Eingabe-Datensymbolen ab. Als Rückgriffstiefe L wird die Anzahl von Datensymbolen (Binärzeichen) bezeichnet, die bei ADD1 für eine Verknüpfung zur Verfügung stehen, d.h. hier L = 4.

Der Aufbau des zweiten Faltungscodierers RSC2 ist identisch mit dem Aufbau des ersten Faltungscodierers RSC1; an seinem Ausgang stellt RSC2 eine Redundanz-Datenfolge $Y2 = (y2_1, y2_2, .., y2_N)$ bereit.

Die unveränderte Eingabesignalfolge U kann als zweiter Ausgang des ersten Faltungscodierers RSC1 angesehen werden, das heißt bei dieser Betrachtungsweise umfaßt der erste Faltungscodierer RSC1 einen zweiten Ausgang, an dem die Datenfolge X ausgegeben wird, deren Elemente $x_1, x_2, .., x_N$ identisch mit den Elementen $u_1, u_2, .., u_N$ der Eingabesignalfolge U sind. Analoges gilt für den zweiten Faltungscodierer RSC2 und einen zweiten Ausgang desselben, der identisch mit der verschachtelten Eingabesignalfolge U ist. Codierer mit dieser Eigenschaft werden allgemein als systematische Codierer bezeichnet.

Es werden dann pro Eingabe-Datensymbol $u_n$ von jedem Faltungscodierer RSC1 bzw. RSC2 genau zwei Ausgabe-Datensymbole $x_n$ und $y1_n$ bzw. $x_n$ und $y2_n$ ausgegeben. Jeder Faltungscodierer RSC1, RSC2 weist somit eine Coderate $R_C = 0,5$ auf.

Die Multiplexereinrichtung MUX dient zur Einstellung der Coderate des Turbo-Codierers TCOD. Um auch für TCOD eine Coderate von z.B. $R_C = 0,5$ zu erreichen, werden die beiden Redundanz-Teilfolgen Y1 und Y2 alternierend punktiert und multiplexiert. Die sich dabei ergebende Redundanz-Datenfolge $Y = (y1_1, y2_2, y1_3, y2_4, .., y1_N, y2_N)$ wird nachfolgend alternierend mit der systematischen Datenfolge X multiplexiert. Das sich bei dieser (speziellen) Form der Turbocodierung ergebende fehlerschutzcodierte Datensignal weist demzufolge (N sei als eine gerade Zahl angenommmen) die Form $D = (x_1, y1_1, x_2, y2_2, x_3, y1_3, x_4, y2_4, .., x_N, y2_N)$ auf.

Der Faltungscodierer RSC1 kann als endlicher, getakteter Automat aufgefaßt und durch ein sog. Trellis-Diagramm mit M möglichen Zuständen beschrieben werden. Das Trellis-Diagramm des Faltungscodierers RSC1 mit einem Schieberegister aus 3 Zellen weist $M = 2^3 = 8$ Knoten auf, die den möglichen Zuständen des Schieberegisters entsprechen. Ein (beliebiger) erster Zustand m, der durch Eingabe eines Eingangsbits ($u_n = 0$ oder 1) in einen zweiten Zustand m' übergeht, ist mit diesem im Trellis-Diagramm durch eine Verbindungslinie verbunden. Jede Redundanzteilfolge Y1 entspricht einem bestimmten Weg entlang Verbindungslinien durch das Trellis-Diagramm des RSC1-Codierers.

Trellis-Diagramme zur Veranschaulichung der Zustände von Codierern sind bekannt und werden hier nicht näher erläutert.

Das erfindungsgemäße Decodierverfahren wird nachfolgend unter Bezugnahme auf den in Fig. 4 gezeigten Turbo-Decodierer TDEC erläutert.

Der Turbo-Decodierer TDEC umfaßt einen ersten und einen zweiten Demultiplexer DMUX1 und DMUX2, einen Speicher MEM, einen ersten und zweiten Faltungsdecodierer DEC1 und DEC2, einen Verschachteler IL, einen ersten und einen zweiten Entschachteler DIL1 und DIL2 sowie eine Entscheidungslogik (Schwellenwertentscheider) TL.

Die Faltungsdecodierer DEC1 und DEC2 sind Symbolschätzer.

Die von dem Demodulator DMOD dem Turbo-Decodierer TDEC zugeführte entzerrte Datenfolge $\hat{D} = (\hat{x}_1, \hat{y1}_1, \hat{x}_2, \hat{y2}_2, \hat{x}_3, \hat{y1}_3, \hat{x}_4, \hat{y2}_4, .., \hat{x}_N, \hat{y2}_N)$ wird von dem ersten Demultiplexer DMUX1 in die entzerrte systematische Datenfolge $\hat{X}$ (detektierte Version der Eingabesignalfolge U (= X)) und die entzerrte Redundanzfolge $\hat{Y}$ (detektierte Version der Redundanzfolge Y) aufgespalten.

Der zweite Demultiplexer DMUX2 spaltet die entzerrte Redundanzfolge Y in die beiden entzerrten Redundanz-Teilfolgen Y1 und Y2 (detektierte Versionen der Redundanz-Teilfolgen Y1 und Y2) auf. Mit $x_n$, $y1_n$, $y2_n$ (n = 1, 2, .., N) werden die entzerrten (geschätzten) Versionen der sendeseitig auftretenden Datensymbole $x_a$, $y1_n$, $y2_n$ bezeichnet.

Der erste Decodierer DEC1 berechnet ausgehend von den Folgen $\hat{X}$ und $\hat{Y1}$ und einer Rückkopplungsfolge Z eine Folge von Zuverlässigkeitsinformation $\Lambda1 = (\Lambda1(u_1), \Lambda1(u_2), .., \Lambda1(u_N))$

Jedes Element $\Lambda1(u_n)$ der Folge $\Lambda1$ ist ein wertekontinuierliches logarithmisches Wahrscheinlichkeitsverhältnis für das uncodierte Datensymbol $u_n$ der Eingabesignalfolge U,

$$\Lambda1(u_n) = \ln\left\{\frac{P\left(u_n = 1 | \hat{X}, \hat{Y1}, Z\right)}{P\left(u_n = 0 | \hat{X}, \hat{Y1}, Z\right)}\right\} \qquad (1)$$

Mit $P(u_n = 1 | \hat{X}, \hat{Y1}, Z)$ bzw. $P(u_n = 0 | \hat{X}, \hat{Y1}, Z)$ werden die bedingten Wahrscheinlichkeiten dafür bezeichnet, daß das Datensymbol $u_n$ gleich 1 bzw. gleich 0 ist unter der Bedingung, daß die Folgen X,Y1,Z beobachtet werden. Diese bedingten Wahrscheinlichkeiten sind "Wahrscheinlichkeiten a-Posteriori", da von einem eingetretenen Ereignis (den detektierten Folgen X,Y1,Z) auf die Wahrscheinlichkeiten der diesem Ereignis zugrundeliegenden, uncodierten Datensymbole (hier: Bits) $u_1$ bis $u_N$ rückgeschlossen wird.

Die Element $\Lambda1(u_n)$ der Folge von Zuverlässigkeitsinformation $\Lambda1$ werden auch als LLRs (Log-Likelihood Ratios) bezeichnet.

Die Folge von Zuverlässigkeitsinformation $\Lambda1$ wird von dem Verschachteler IL verschachtelt und als verschachtelte Folge von Zuverlässigkeitsinformation $\Lambda1_I$ dem zweiten Faltungsdecodierer DEC2 zugeführt. Der zweite Faltungsdecodierer DEC2 berechnet aus der verschachtelten Folge von Zuverlässigkeitsinformation $\Lambda1_I$ und aus der Folge Y2 eine verschachtelte Rückkopplungsfolge $Z_I$ und eine verschachtelte Folge $\Lambda2_I$.

Die verschachtelte Rückkopplungsfolge $Z_I$ wird von dem ersten Entschachteler DIL1 entschachtelt und ergibt die Rückkopplungsfolge Z. Die Elemente $\Lambda2_I(u_n)$ der Folge $\Lambda2_I$ sind ebenfalls wertekontinuierliche a-Posteriori-Wahrscheinlichkeitsverhältnisse für die uncodierten Datensymbole $u_1$ bis $u_N$ der Eingabesignalfolge U, d.h.

$$\Lambda2_I(u_n) = \ln\left\{\frac{P\left(u_n = 1 | \Lambda1_I, \hat{Y2}\right)}{P\left(u_n = 0 | \Lambda1_I, \hat{Y2}\right)}\right\} \qquad (2)$$

wobei die bereits erläuterte Notation verwendet wird.

Die Folge $\Lambda2_I$ wird von dem zweiten Entschachteler DIL2 entschachtelt und als entschachtelte Folge $\Lambda2$ der Entscheidungslogik TL zugeführt. Die Entscheidungslogik TL bestimmt für jedes Element $\Lambda2(u_n)$ der Folge $\Lambda2$ mit einem Wert $\leq 0$ ein rekonstruiertes Datensymbol $\hat{u}_n = 0$ und für jedes Element von $\Lambda2$ mit einem Wert $> 0$ ein rekonstruiertes Datensymbol (Bit) $\hat{u}_n = 1$.

Charakteristisch für ein Turbo-Decodierverfahren ist die Berechnungsweise der LLRs $\Lambda1(u_n)$ und $\Lambda2_I(u_n)$. Im folgenden wird die rekursive Berechnung von $\Lambda1$ erläutert.

Der Zustand des Faltungscodierers RSC1 zum Zeitpunkt n (d.h. beim Eingabe-Datensymbol $u_n$) wird mit $S_n$ bezeichnet.

Die bedingten a-Posteriori-Wahrscheinlichkeiten in der Gleichung 1 lassen sich als Summen von Einzel-a-Posteriori-Wahrscheinlichkeiten über die M möglichen Zustände des Codierers RSC1 ausdrücken:

$$\Lambda1(u_n) = \ln\left\{\frac{\sum_{m=1}^{M} P\left(u_n = 1, S_n = m | \hat{X}, \hat{Y1}, Z\right)}{\sum_{m=1}^{M} P\left(u_n = 0, S_n = m | \hat{X}, \hat{Y1}, Z\right)}\right\} \qquad (3)$$

Die Einzelwahrscheinlichkeiten können in der folgenden Form geschrieben werden

$$P\left(u_n = i, S_n = m \middle| \hat{X}, \hat{Y1}, Z\right) = \alpha_n^i(m) \cdot \beta_n(m)$$

i = 0, 1 mit

$$\alpha_n^i(m) = P\left(u_n = i, S_n = m \middle| R_1^n\right)$$

$$\beta_n(m) = \frac{P\left(R_{n+1}^N \middle| S_n = m\right)}{P\left(R_{n+1}^N \middle| R_1^N\right)} \qquad\qquad (4)$$

wobei zur Vereinfachung der Schreibweise die Folge

$$R_\nu^\mu = (R_\nu, .., R_\mu), \qquad 1 \le \nu < \mu \le N \qquad\qquad (5)$$

bestehend aus den Wertetripeln $R_n = (x_n, y1_n, z_n)$ von systematischer Information, Redundanzinformation und Rekursionsinformation definiert wird.

Der Ausdruck $\alpha_n^i(m)$ kann durch eine Vorwärtsrekursion und der Ausdruck $\beta_n(m)$ kann durch eine Rückwärtsrekursion berechnet werden. Die Ausdrücke werden daher auch als Vorwärts- und Rückwärtsmetriken bezeichnet. Eine detaillierte Beschreibung der Rekursionen (bei Verwendung einer (optimalen) MAP-Symbolschätzung) ist in dem Kapitel E.3.3 "Rekursive MAP-Symbolschätzung" des genannten Buchs von P. Jung auf den Seiten 353 bis 361 angegeben. Die Rekursionen laufen über den gesamten Block, d.h. die Vorwärtsrekursion beginnt beim Zeitpunkt 1 (erstes Bit der Folgen X,Y1,Z) und endet im Zeitpunkt N (letztes Bit der Folgen X,Y1,Z) und die Rückwärtsrekursion beginnt beim Zeitpunkt N und endet im Zeitpunkt 1.

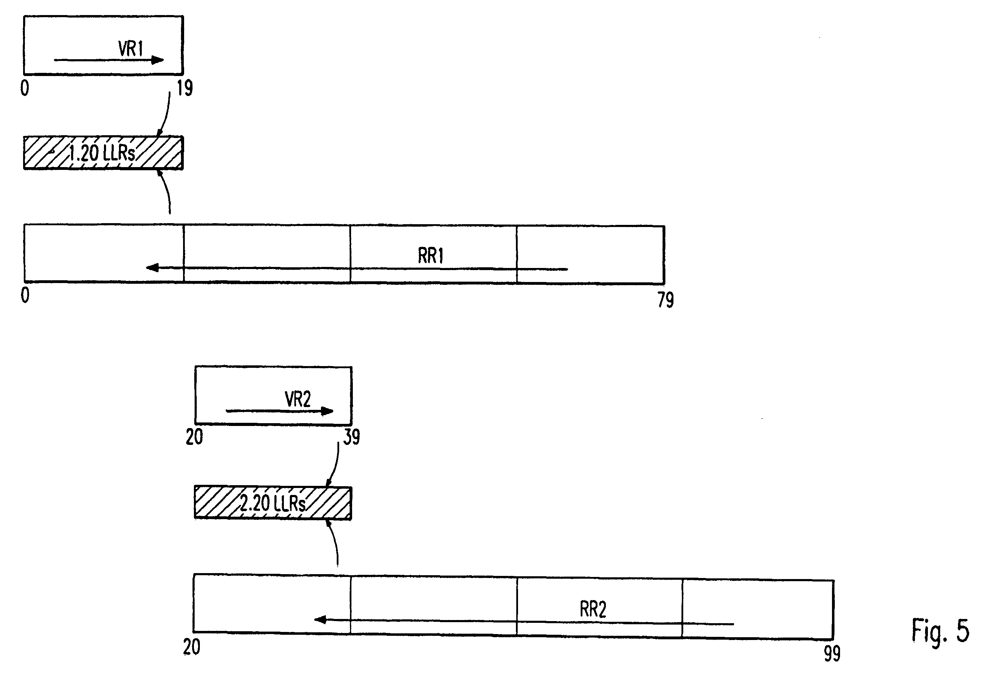

Im folgenden wird anhand Fig. 5 ein Ausführungsbeispiel des erfindungsgemäßen Verfahrens mit mehreren Teilintervall-Rekursionsläufen zur Berechnung der LLRs aus Gleichungen (1), (3) erläutert.

Beispielsweise sei N = 300. Beginnend bei n = 0 werden in einem ersten Vorwärtsrekursionslauf VR1 zunächst z.B. die ersten Werte 20 Werte $\alpha_0^i(m)$, .., $\alpha_{19}^i(m)$ bestimmt und in einem Vorwärtsrekursions-Speicherbereich (nicht dargestellt) des Faltungsdecodierers DEC1 zwischengespeichert.

Die zugehörige erste Rückwärtsrekursion RR1 beginnt hier beispielsweise bei n = 79 und läuft bis n = 0. Es werden die entsprechenden Werte für $\beta_n(m)$ berechnet und in einem Rückwärtsrekursions-Speicherbereich (nicht dargestellt) des Faltungsdecodierers DEC1 zwischengespeichert

Zur Berechnung der LLRs im Blocksegment n = 0, 1, .., 19 werden sämtliche 20 berechneten Werte für $\alpha_n^i$(m) und die letzten zwanzig berechneten Werte für $\beta_n(m)$ herangezogen.

Nach der Berechnung der ersten 20 LLRs werden die beiden Rekursionsintervalle (Rekursionsfenster) jeweils um 20 Werte verschoben. Die zweite Vorwärtsrekursion VR2 beginnt demzufolge bei n = 20 und läuft bis n = 39. Bei der Zwischenspeicherung der Werte $\alpha_{20}^i(m)$, .., $\alpha_{39}^i(m)$ können die bei der ersten Vorwärtsrekursion VR1 gewonnenen Ergebnisdaten überschrieben werden. Die zugehörige zweite Rückwärtsrekursion RR2 beginnt bei n = 99 und läuft bis n = 20 zurück. Die bei der ersten Rückwärtsrekursion RR1 ermittelten Ergebnisdaten können auch hier durch die neuen Datenwerte $\beta_n(m)$, n = 99 bis 20, überschrieben werden. Zur Berechnung der LLRs im Blocksegment n = 20, 21, .., 39 werden wiederum sämtliche 20 berechneten Werte für $\alpha_n^i(m)$ und die letzten zwanzig berechneten Werte für $\beta_n(m)$ herangezogen.

Diese segmentweise Bestimmung der LLRs mit gleitenden Vorwärts- und Rückwärtsrekursionsfenstern wird in der beschriebenen Weise fortgeführt, bis sämtliche LLRs des Datenblockes berechnet sind. Aufgrund der segmentweisen Berechnungsweise ist die Datenmenge, die bei Abarbeitung eines Blocksegments zwischengespeichert werden muß, gegenüber den im Stand der Technik eingesetzten, blockübergreifenden Rekursionsläufen deutlich verringert.

Es ist auch möglich und unter dem Gesichtspunkt der Speicherplatzökonomie bevorzugt, ohne Rückwärtsrekursions-Speicherbereich auszukommen. Bei einer solchen Ausführung der Hardware werden die LLRs des jeweiligen Blocksegmentes aus den gespeicherten Vorwärtsrekursionswerten und den aktuell errechneten Rückwärtsrekursionswerten direkt (d.h. ohne Zwischenspeicherung der letzteren) berechnet.

Die in Fig. 5 dargestellten Vorwärts- und Rückwärtsrekursionen lassen sich in vorteilhafter Weise folgendermaßen verallgemeinern: Mit D(VR) wird die Länge des Vorwärtsrekursionsfensters (hier = 20) bezeichnet und mit D (RR) wird die Länge des Rückwärtsrekursionsfensters (hier: 80) bezeichnet. Die Länge des Rückwärtsrekursionsfensters bestimmt sich gemäß der Beziehung D(RR) = L x D(VR), wobei L die Rückgriffstiefe (im vorliegenden Beispiel L = 4) ist.

Im folgenden werden zwei Möglichkeiten zur Berechnung der Vorwärts- und Rückwärtsrekursionsausdrücke $\alpha_n^i(m)$, $\beta_n(m)$ angegeben.

Nach einer ersten, bekannten Möglichkeit, die detailliert in dem Kapitel E.3.3 "Rekursive MAP-Symbolschätzung" des genannten Buchs von P. Jung auf den Seiten 353 bis 361 beschrieben ist, das diesbezüglich durch Bezugnahme zum Gegenstand dieser Schrift wird, ergibt sich für die Vorwärtsrekursion bei Durchführung einer MAP-Symbolschätzung

$$\alpha_n^i(m) = \frac{\sum_{m'=1}^{M} \sum_{j=0}^{1} \gamma_n^i(R_n, m', m) \cdot \alpha_{n-1}^j(m')}{\sum_{m=1}^{M} \sum_{m'=1}^{M} \sum_{k=0}^{1} \sum_{j=0}^{1} \gamma_n^k(R_n, m', m) \cdot \alpha_{n-1}^j(m')} \quad , \qquad (6)$$

i = 0, 1 n = 1, .., N und für die Rückwärtsrekursion

$$\beta_n(m) = \frac{\sum_{m'=1}^{M} \sum_{j=0}^{1} \gamma_{n+1}^j(R_{n+1}, m, m') \cdot \beta_{n+1}(m')}{\sum_{m=1}^{M} \sum_{m'=1}^{M} \sum_{k=0}^{1} \sum_{j=0}^{1} \gamma_{n+1}^k(R_{n+1}, m', m) \cdot \alpha_n^j(m')} , \qquad (7)$$

m = 1, .., M n = 1, .., N

Die Ausdrücke $\gamma_n^i(R_n, m', m)$ sind die Übergangswahrscheinlichkeiten von einem ersten Zustand $S_{n-1} = m'$ in einen zweiten Zustand $S_n = m$ des Codierers RSC1 im Trellis-Diagramm, d.h.

$$\gamma_n^i(R_n, m', m) = P\left(u_n = i, S_n = m, R_n \middle| S_{n-1} = m'\right) \qquad (8)$$

Im folgenden wird eine zweite Möglichkeit zur Berechnung der Vorwärts- und Rückwärtsrekursionsausdrücke $\alpha_n^i(m)$, $\beta_n(m)$ angegeben. Wie aus den folgenden Gleichungen ersichtlich, ist bei dieser zweiten Möglichkeit der Rechenaufwand im Vergleich zur ersten Möglichkeit erheblich reduziert.

$$\alpha_n^i(m) = \sum_{m'=0}^{M} \sum_{j=0}^{1} \alpha_{n-1}^j(m') \cdot \gamma_n^i(R_n, m', m) , \qquad (9)$$

i = 0, 1, n = 1, .., N

$$\beta_n(m) = \sum_{m'=1}^{M} \sum_{j=0}^{1} \beta_{n+1}(m') \cdot \gamma_{n+1}^j(R_{n+1}, m, m') , \qquad (10)$$

mit m = 1, .., M, n = 1, .., N

Im Unterschied zu den nach den Gleichungen 6 und 7 (in Verbindung mit den Gleichungen 1, 3 und 4) berechneten LLRs (1. Möglichkeit) werden nach den Gleichungen 9 und 10 (2. Möglichkeit) bei den Rekursionen keine Verhältnisse von Wahrscheinlichkeiten, sondern die Wahrscheinlichkeiten direkt berechnet. Dies hat zwar eine Erhöhung der Rechenungenauigkeit zur Folge, vorteilhaft ist jedoch die erheblich geringere Anzahl von Rechenschritten. Die zweite Möglichkeit wird daher auch als suboptimale MAP-Symbolschätzung bezeichnet.

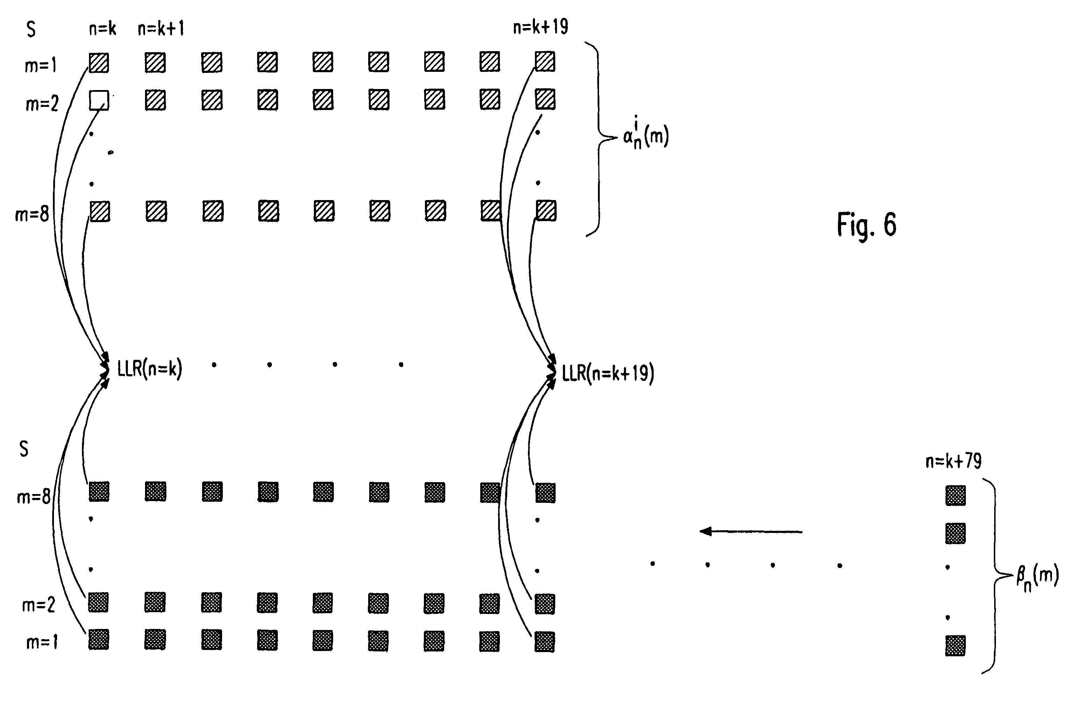

Fig. 6 veranschaulicht die Summation über die M Zustände des Codierers RSC1, die zur Berechnung der 20 LLRs eines Blocksegments, das sich von n = k bis n = k + 19, erstreckt gemäß der Vorwärts-Rekursionsgleichung (6) oder (9) und der Rückwärts-Rekursionsgleichung (7) oder (10) durchgeführt werden müssen.

Bei der ersten Vorwärtsrekursion in einem Block (d.h. bei k = 0) werden sämtliche Vorwärtsrekursionsausdrücke $\alpha_0^i$ (m) mit Ausnahme der Vorwärtsrekursionsausdrücke für den Anfangszustand m = 1 auf den Wert 0 initialisiert. Der Anfangszustand m = 1 ist dem Empfänger durch vorherige Übereinkunft bekannt und wird korrekt initialisiert. Bei der ersten Rückwärtsrekursion (k = 0) in einem Block liegt keine Kenntnis des Rückwärtsrekursion-Anfangszustands vor, d.h. jeder mögliche Zustand ist gleichwahrscheinlich. Demgemäß werden sämtliche Anfangswerte $\beta_{80}$(m) auf den Wert 1/M gesetzt.

Bei der zweiten und allen folgenden Vorwärtsrekursionen werden die in der jeweils vorhergehenden Vorwärtsrekursion erhaltenen Vorwärtsrekursionsausdrücke normiert und sodann als Anfangswerte der aktuellen Vorwärtsrekursion verwendet. Das heißt, die Vorwärtsrekursionsausdrücke bauen nicht nur innerhalb eines Rekursionsfensters sondern auch bezüglich aufeinanderfolgender Rekursionsfenster aufeinander auf. Demgegenüber sind bei den Rückwärtsrekursionen (außer bei der letzten Rückwärtsrekursion) die Anfangszustände stets unbekannt, d.h. die Anfangswerte bei den Rückwärtsrekursionen werden stets auf 1/M gesetzt. Eine Ausnahme gilt lediglich für die letzte Rückwärtsrekursion in einem Block, da hier der Endzustand im Trellis-Diagramm bekannt ist.

Eine Normierung der Rückwärtsrekursionsausdrücke (als Anfangswerte für die darauffolgende Rückwärtsrekursion) ist aufgrund der relativ kleinen Rückwärtsrekursions-Fenstergröße im Vergleich zu der gesamten möglichen Länge des Trellis-Diagramms nicht erforderlich.

Es wird deutlich, daß bei der Berechnung der LLRs gemäß Fig. 6 sämtliche möglichen Zustände des Codierers RSC1 berücksichtigt werden.

## Patentansprüche

1. Verfahren zum blockweisen Decodieren eines senderseitig mit einem Turbo-Code fehlerschutzcodierten, über einen Funkkanal übertragenen und in einem Empfänger (E) detektierten Datensignals (D) mittels eines zwei rückgekoppelte Symbolschätzer (DEC1, DEC2) umfassenden Turbo-Decodierers (TDEC), bei welchem zumindest einer der Symbolschätzer (DEC1; DEC2) zur Berechnung von Ausgabewerten (LLR) eine Vorwärtsrekursion und eine Rückwärtsrekursion ausführt, wobei

   - dieser Symbolschätzer (DEC1; DEC2) zur Berechnung der Ausgabewerte (LLR) für einen Datenblock eine Mehrzahl von Vorwärts- und/oder Rückwärtsrekursionen über Teilintervalle (VR1, VR2; RR1, RR2) des Datenblocks durchführt;
   - ein Teilintervall (VR1, VR2) für eine Vorwärtsrekursion D(VR) Datenwerte lang ist,
   - ein Teilintervall (RR1, RR2) für eine Rückwärtsrekursion D(RR) Datenwerte lang ist, und
   - D(RR) = D(VR) x L gilt, wobei L die Rückgriffstiefe eines bei der Codierung eingesetzten rekursiven Faltungscodierers (RSC1, RSC2) ist.

2. Verfahren nach Anspruch 1,
   **dadurch gekennzeichnet,**

   - **daß** die Teilintervalle (VR1, VR2) für die Vorwärtsrekursionen den Datenblock vollständig und überlappungsfrei überdecken.

3. Verfahren nach Anspruch 1 oder 2,
   **dadurch gekennzeichnet,**

   - **daß** jedem Teilintervall (VR1, VR2) für eine Vorwärtsrekursion ein Teilintervall (RR1, RR2) für eine Rückwärtsrekursion zugeordnet ist, welches das Teilintervall (VR1, VR2) für die Vorwärtsrekursion enthält, und
   - **daß** der Berechnung des n-ten Ausgabewertes des Datenblocks lediglich eine Vorwärtsrekursion über das den n-ten Datenwert enthaltende Teilintervall und eine Rückwärtsrekursion über das zugeordnete Teilintervall zugrunde liegen.

**4.** Verfahren nach einem der vorhergehenden Ansprüche,
**dadurch gekennzeichnet,**

- **daß** D(VR) zwischen 10 und 30 liegt, insbesondere 20 ist.

**5.** Verfahren nach einem der vorhergehenden Ansprüche,
**dadurch gekennzeichnet,**

- **daß** bei einer Rekursion über ein Teilintervall (VR1; RR1) berechnete Metriken des Turbo-Codes als Anfangswerte bei der darauffolgenden Rekursion (VR2, RR2) gleicher Richtung eingesetzt werden.

**6.** Verfahren nach einem der vorhergehenden Ansprüche,
**dadurch gekennzeichnet,**

- **daß** zur Berechnung der Ausgangswerte (LLR) des betrachteten Symbolschätzers (DEC1) ein suboptimaler MAP-Algorithmus verwendet wird.

**Claims**

**1.** Method for blockwise decoding of a data signal (D), which is error protection coded at the transmitter end with the aid of a turbo code, transmitted via a radio channel and detected in a receiver (E), by means of a turbo decoder (TDEC) that comprises two feedback symbol estimators (DEC1, DEC2), in the case of which method at least one of the symbol estimators (DEC1; DEC2) executes a forward recursion and a backward recursion in order to calculate output values (LLR),

- in which this symbol estimator (DEC1; DEC2) carries out a plurality of forward and/or backward recursions over subintervals (VR1, VR2; RR1, RR2) of the data block in order to calculate the output values (LLR) for a data block;
- a subinterval (VR1, VR2) for a forward recursion is D(VR) data values long,
- a subinterval (RR1, RR2) for a backward recursion is D(RR) data values long, and
- it holds that D(RR) = D(VR) x L, L being the fallback depth of a recursive convolutional coder (RSC1, RSC2) used in the coding.

**2.** Method according to Claim 1,
**characterized**

- **in that** the subintervals (VR1, VR2) for the forward recursions cover the data block completely and without overlap.

**3.** Method according to Claim 1 or 2,
**characterized**

- **in that** each subinterval (VR1, VR2) for a forward recursion is assigned for a backward recursion a subinterval (RR1, RR2) which includes the subinterval (VR1, VR2) for the forward recursion, and
- **in that** the calculation of the nth output value of the data block is based only on a forward recursion over the subinterval including the nth data value, and on a backward recursion over the assigned subinterval.

**4.** Method according to one of the preceding claims,
**characterized**

- **in that** D(VR) lies between 10 and 30, in particular is 20.

**5.** Method according to one of the preceding claims,
**characterized**

## EP 1 249 074 B1

- **in that** in the case of recursion over a subinterval (VR1; RR1), calculated metrics of the turbo code are used as initial values in the subsequent recursion (VR2, RR2) of the same direction.

6. Method according to one of the preceding claims,
   **characterized**

   - **in that** a suboptimal MAP algorithm is used to calculate the output values (LLR) of the symbol estimator (DEC1) considered.

**Revendications**

1. Procédé pour le décodage par bloc d'un signal de données (D), codé pour la protection contre les erreurs du côté émetteur avec un turbocode, transmis via un canal radio et détecté dans un récepteur (E), au moyen d'un turbodécodeur (TDEC) comprenant deux estimateurs de symbole (DEC1, DEC2) avec rétroaction, dans lequel au moins l'un des estimateurs de symbole (DEC1 ; DEC2) exécute pour le calcul de valeurs de sortie (LLR) une récursion en avant et une récursion en arrière,

   - cet estimateur de symbole (DEC1 ; DEC2) effectuant pour le calcul des valeurs de sortie (LLR), pour un bloc de données, une multiplicité de récursions en avant et/ou en arrière sur des sous-intervalles (VR1, VR2 ; RR1, RR2) du bloc de données,
   - un sous-intervalle (VR1, VR2) pour une récursion en avant ayant une longueur de D (VR) valeurs de données,
   - un sous-intervalle (RR1, RR2) pour une récursion en arrière ayant une longueur de D (RR) valeurs de données, et
   - D (RR) = D (VR) x L, L étant la profondeur de régression d'un codeur à convolution récursif (RSC1, RSC2) utilisé lors du codage.

2. Procédé selon la revendication 1,
   **caractérisé par le fait que**

   - les sous-intervalles (VR1, VR2) pour la récursion en avant recouvrent le bloc de données complètement et sans chevauchement.

3. Procédé selon la revendication 1 ou 2,
   **caractérisé par le fait que**

   - il est associé à chaque sous-intervalle (VR1, VR2) destiné à une récursion en avant un sous-intervalle (RR1, RR2) destiné à une récursion en arrière, lequel contient le sous-intervalle (VR1, VR2) destiné à la récursion en avant, et
   - il y a à la base du calcul de la n-ème valeur de sortie du bloc de données simplement une récursion en avant sur le sous-intervalle contenant le n-ème bloc de données et une récursion en arrière sur le sous-intervalle associé.

4. Procédé selon l'une des revendications précédentes,
   **caractérisé par le fait que**

   - D (VR) est comprise entre 10 et 30, notamment est égale à 20.

5. Procédé selon l'une des revendications précédentes,
   **caractérisé par le fait que**

   - on utilise des métriques du turbocode qui ont été calculées lors d'une récursion sur un sous-intervalle (VR1; RR1) comme valeurs initiales lors de la récursion suivante (VR2, RR2) de même sens.

6. Procédé selon l'une des revendications précédentes,
   **caractérisé par le fait que**

   - pour le calcul des valeurs de sortie (LLR) de l'estimateur de symbole (DEC1) considéré, on utilise un algorithme

MAP sous-optimal.

Fig. 1

Fig. 2

$u_1, u_2, ..., u_N$
U

$x_1, x_2, ..., x_N$
X

RSC1

T      T      T

ADD1

ADD2

$y1_1, y1_2, ..., y1_N$
Y1

Fig. 3

TDEC

DIL1      Z

$\hat{X}$

Z      DEC1      $\Lambda 1$      IL      $\Lambda 1_I$      DEC2      $Z_I$

$\hat{D}$      $\hat{Y}1$      $\Lambda 2_I$

$\hat{Y}$      DIL2

DMUX1      $\hat{Y}2$      MEM      $\hat{Y}2$      $\Lambda 2$

DMUX2      TL

$\hat{U}$

Fig. 4

EP 1 249 074 B1

VR1

0          19

1.20 LLRs

RR1

0                                                    79

VR2

20          39

2.20 LLRs

RR2

20                                                    99

Fig. 5

Fig. 6